(19) Europäisches Patentamt / European Patent Office / Office européen des brevets

(11) **EP 3 671 348 A1**

(12) **EUROPEAN PATENT APPLICATION**

(43) Date of publication:
**24.06.2020 Bulletin 2020/26**

(21) Application number: **18215347.8**

(22) Date of filing: **21.12.2018**

(51) Int Cl.:
***G03F 9/00*** *(2006.01)*

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Mycronic AB**
**183 03 Täby (SE)**

(72) Inventor: **Jonsson, Fredrik**
**183 03 TÄBY (SE)**

(74) Representative: **AWA Sweden AB**
**P.O. Box 45086**
**104 30 Stockholm (SE)**

(54) **PNEUMATIC SENSOR FOR REAL-TIME FOCUSING**

(57)    The present disclosure provides a method for focusing of an optical beam during projection onto a photo-sensitive resist, including passing a first stream of gas from a domain of a first pressure (210) through a constriction (220) to a domain of a second pressure (230) lower than the first pressure; measuring the second pressure; passing a second stream of gas from the domain of the second pressure, through an opening connected to the domain of the second pressure and arranged at a first distance to projection optics for the optical beam, through a space (240) formed between a) the opening and b) a surface of the photo-sensitive resist, and into a domain of a third pressure (250) lower than the second pressure, and focusing the optical beam with respect to the photo-sensitive resist by adjusting at least one of the first distance and a second distance between the opening and the surface of the photo-sensitive resist based on the measured second pressure. Various devices and a pattern generating system is also provided.

*Fig. 1*

EP 3 671 348 A1

**Description**

<u>Technical field</u>

The present disclosure relates to the field of optical microlithography. In particular, the present disclosure relates to a focus system for use when projecting an optical beam onto a photo-sensitive resist.

<u>Background</u>

In optical microlithography, the achieved performance may rely on the focus system, on how deviations of the topography of the photo-sensitive resist to be exposed are kept track of, and on how such deviations are subsequently corrected for by for example altering the spatial position of the projection optics of the optical system used for the exposure with respect to the photo-sensitive resist.

In order to track such deviations, prior solutions employ a flow of air through a nozzle which is brought close to the photo-sensitive resist. By measuring the speed of the air flow through the nozzle, the nozzle height above the photo-sensitive resist may be extracted and the use of other techniques, such as for example light and interferometry or triangulation, which may be potentially harmful to the photo-sensitive resist, may be avoided. In prior solutions, the air flow is often measured in terms of mass flow through tubes leading to the nozzle, by using an electrical measurement of a heated filament cooled by the air flow around it.

However, employing such air flow measurements in order to focus the projection optics comes with several disadvantages. First, the flow sensor typically generates heat, and the flow sensor therefore needs to be placed at a significant distance away from the often heat-sensitive projection optics and photo-sensitive resist. The tubes and connectors needed for such a placement may introduce a pneumatic reservoir and resistance needed to be overcome before a change in air flow may actually be detected. This may in turn lead to a slower response for the sensor, a slower feedback to the focus system and hence a less responsive autofocus, leading to larger lithographic variation of performance from the optimum.

Secondly, measurement of air flow in order to maintain focus may require a significant flow of air in order for the focus system to operate correctly. This in turn may imply a significant air flow from the nozzle directly across the photo-sensitive resist, which may dry out the resist and be potentially harmful to the chemical process of exposure and subsequent development. At the same time, the required significant air flow may reduce the possibilities of tailoring the design parameters for the system, for example a desired nominal height of placement of the nozzle position.

In light of the above, there is therefore a need for an improved way of focusing the projection optics onto the photo-sensitive resist during exposure thereof.

<u>Summary</u>

To at least partially fulfill the above needs, the present disclosure provides a method and device as defined in the independent claims. Further embodiments of the present disclosure are provided in the dependent claims.

According to a first aspect of the present disclosure, a method for focusing of an optical beam during projection onto a photo-sensitive resist is provided. The method may include passing a first stream of gas from a domain of a first pressure through a constriction to a domain of a second pressure. The second pressure may be lower than the first pressure. The method may include measuring the second pressure. The method may include passing a second stream of gas through an opening (such as e.g. a nozzle) connected to the domain of the second pressure and arranged at a first distance to projection optics for the optical beam, through a space formed between a) the opening and b) a surface of the photo-sensitive resist, and into a domain of a third pressure. The third pressure may be lower than the second pressure. The method may further include focusing the optical beam with respect to the photo-sensitive resist by adjusting at least one of the first distance and a second distance between the opening the surface of the photo-sensitive resist based on the measured second pressure.

The constriction may for example be located inside, or form, the inlet to the domain of the second pressure. The opening arranged at the projection optics may for example be located inside, or form, an outlet from the domain of the second pressure.

The gas flow resistance in passage from the first domain (e.g. from an external pressurized reservoir of gas) to the second domain (e.g. to an interior cavity of a proximity sensor as will be defined later herein) may be comparable to the gas flow resistance from the second domain via the opening over to ambient pressure. As a result, when varying the distance between the opening and the photo-sensitive resist (e.g. by adjusting the second distance), the pressure in the second domain (the cavity of the proximity sensor) may be varied accordingly. The possible variation may extend from the value of the input pressure evaluated at an inlet to the domain of the second pressure (including e.g. the constriction and connection tubes), corresponding to the case when the opening makes mechanical contact with the surface of the photo-sensitive resist, to a value given by the pressure obtained between the two gas flow resistances defined by the inlet (including the constriction) and the outlet, corresponding to the case when the opening is brought far from the surface of the photo-sensitive resist. Detecting the pressure in the second domain may therefore allow detecting the actual distance, or at least changes in distance, between e.g. the projection optics and the surface of the photo-sensitive resist as a function of the first distance and the second distance.

The pressure in the second domain (cavity) may for example be measured relative the ambient pressure (in the third domain) or relative the pressure of the first domain (e.g. an external pressurized reservoir). Since a pressure sensor needed to measure the pressure within e.g. the second domain (cavity) does not rely on e.g. a heated filament, the pressure sensor may be placed in direct contact with the gas (such as air) in the second domain and one may obtain a faster response to any deviations of the gap between the opening and the surface of the photo-sensitive resist. Meanwhile, a significantly larger span of choices for point of operation may be made available. This may apply specifically for the nominal free height of opening placement above the resist, as the use of the pressure sensor avoids the above described common problems with gas flow sensors, such as comparatively high required gas flows and heat generation. In addition to providing a faster response, the use of the pressure sensor in accordance with the present disclosure also enables operation at lower flow rates of the gas. As described earlier herein, a lower flow rate may be beneficial in that it does not dry out the photo-sensitive resist or provide chemically reactive effects of the gas upon the photo-sensitive resist to be exposed.

The various pressures referred to herein may for example be pneumatic pressures.

In some embodiments, the focusing of the optical beam with respect to the photo-sensitive resist may include adjusting the second distance such that the measured second pressure is maintained at a nominal level. This may be performed using for example a feedback loop.

In some embodiments, a cross section of the constriction may be dimensioned such that a free flow of gas is limited by (or kept below) a maximum predesignated level. Here, the free flow of gas refers to the flow of gas through the variable opening when the projection optics and the surface of the photo-sensitive resist are brought apart (e.g. when they are far away from each other).

In some embodiments, the maximum predesignated level corresponds to a maximum allowed gas flow for the photo-sensitive resist, i.e. a maximum allowed gas flow below which the photo-sensitive resist is not dried out or chemically damaged or otherwise negatively affected.

In some embodiments, the second pressure may be measured relative an intermediate pressure in a reference branch. The reference branch includes at least two orifices. The at least two orifices may be balanced to match respective pneumatic resistances of an inlet to and the outlet from (e.g. the opening) the domain of the second pressure. Instead of measuring the pressure in the second domain relative one of the pressures in the first or third domain, the reference branch may allow to gauge the pressure in the second domain against a reference designed to follow deviations in either the first or third domain. Further benefits of such a setup will be described in more detail further below.

In some embodiments, the opening connected to the domain of the second pressure contains a cross section of the projected optical beam. This allows to project the optical beam directly through the outlet. Depending on the field of scanning of the optical beam and the numerical aperture of the projection lens, the diameter of the outlet or opening may be adjusted accordingly. Therefore, the pneumatic resistance of the outlet is not always possible to design only according to optimal choices for the pneumatic flow, but rather from the requirements on the optical performance. In other words, the balancing between the pneumatic resistance of the inlet constriction and the nominal pneumatic resistance of the outlet of the opening under some circumstances may require that the inlet resistance is adjusted against the outlet. By coinciding the outlet of gas from the opening with the optical beam, a more optimal area coverage of the photo-sensitive resist may be obtained, and edge effects on the gas flowing out from the opening (effects which may otherwise be detrimental to the focusing) may be reduced.

In some embodiments, the third pressure may correspond to one standard atmosphere of absolute pressure (i.e. to approximately 1013 mbar).

According to a second aspect of the present disclosure, a device for projection of an optical beam onto a photo-sensitive resist is provided. The device may be configured to receive a substrate onto which at least one layer of the photo-sensitive resist is present. The device may include projection optics configured to project the optical beam onto the photo-sensitive resist when the substrate is received by the device. The device may include a constriction. The device may further include at least one cavity configured to receive gas from an external pressurized reservoir via the constriction. The at least one cavity may for example define at least part of the domain of the second pressure in the corresponding method according to the first aspect. The device may include an opening connected to the at least one cavity and arranged at a first distance from the projection optics, and configured to release the gas from the at least one cavity through a space formable between the opening and a surface of the photo-sensitive resist. The device may further include at least one pressure sensor. The at least one pressure sensor may be configured to measure a pressure inside the at least one cavity relative an ambient pressure or relative pressure of the pressurized reservoir. The device may further include a control system. The control system may be configured to focus the optical beam with respect to the photo-sensitive resist by adjusting at least one of the first distance and a second distance between the opening and the surface of the photo-sensitive resist based on the measure pressure inside the at least one cavity.

According to a third aspect of the present disclosure, a device for projection of an optical beam onto a photo-sensitive resist is provided. The device may include a substrate holder configured to receive a substrate on which at least one layer of the photo-sensitive resist is present. The device may include projection optics configured to project the optical beam towards the substrate holder. The device may include a constriction. The device may include at least one cavity configured to receive gas from an external pressurized reservoir via the constriction. The device may further include an opening connected to the at least one cavity and arranged at a first distance to the projection optics. The opening may be configured to release the gas from the at least one cavity therethrough. The device may include at least one pressure sensor configured to measure a pressure inside the at least one cavity relative an ambient pressure or relative pressure of the pressurized reservoir. The device may further include a control system. The control system may be configured to focus the optical beam with respect to the photo-sensitive resist by adjusting at least one of the first distance and a second distance between the opening and the substrate holder based on the measured pressure inside the at least one cavity.

In some embodiments of the devices, the control system may be configured to focus the optical beam by adjusting the second distance such that the measured pressure inside the at least one cavity is kept at a nominal level.

As made clear by the present disclosure, focusing of the optical beam onto the resist may be achieved in multiple ways, based on the measured pressure within the at least one cavity. In some embodiments, the distance between e.g. the opening and the surface of the photo-sensitive resist, or the distance between e.g. the opening and the substrate holder, may be left unchanged, while the distance between the projection optics and the opening is instead changed based on the measured pressure. This may create a relative movement between the projection optics and the surface of the photo-sensitive resist. It may also be envisaged to change both the first distance and second distance(s) as described above at a same time.

The first domain of the method (according to the first aspect) may correspond to the pressurized external reservoir, the second domain may correspond to the at least one cavity, and the third domain may correspond e.g. to the free space which the gas enters after passing through e.g. the space defined between the opening and the surface of the photo-sensitive resist.

In some embodiments, a cross section of the constriction may be designed in such a way that a maximum gas flow is kept below a predefined maximum level. In some embodiments, the predefined maximum level may preferably correspond to a maximum allowed gas flow for the photo-sensitive resist.

In some embodiments, the opening may have an area, defined as the product of a circumference of the opening and a gap (h) formable between the opening and (the surface of) the photo-sensitive resist when a substrate is received in the device (e.g. in a substrate holder), large enough to allow for a significant pressure drop from the external pressurized reservoir over to the at least one cavity of the device. Herein, a significant pressure drop may correspond to a pressure drop equal to or larger than for example 0.1% of the ambient pressure. Phrased differently, the outlet or opening may have a pneumatic resistance small enough to allow for the significant pressure drop. If the opposite were the case, i.e. if the outlet or opening has a large pneumatic resistance compared to the pneumatic resistance of the inlet, the cavity may essentially have the same pressure regardless of whether the opening is close to or far away from the photo-sensitive resist, possibly only with a very small increase in pressure as the opening approaches mechanical contact with the photo-sensitive resist. Meanwhile, a zero pneumatic resistance of the outlet or opening would not be desirable either, for practical reasons as well as for the fact that a maximum possible span in pressure does not necessarily give an optimal sensitivity at a desired point of operation of the device.

Within the present disclosure, it is envisaged that the opening, the pressure sensor, the constriction and the at least one cavity may form part of a proximity sensor used to determine a distance between the proximity sensor and the surface of the photo-sensitive resist. The opening may form an outlet from the proximity sensor, while the constriction may form part of an inlet to the proximity sensor.

In some embodiments, the device may further include a parallel reference branch. The reference branch may include at least two orifices which may be balanced to match pneumatic resistances of the respective inlet and outlet of the proximity sensor (e.g. of the at least one cavity). As described earlier herein with reference to the method of the first aspect, the pressure inside the cavity of may be gauged against the intermediate pressure between the two orifices of the reference branch, with a zero pressure difference corresponding to the nominal point of operation, with the opening of the device (or proximity sensor) at a nominal distance from the surface of the photo-sensitive resist.

In some embodiments, the device may further include a pressure gauge. The pressure gauge may be configured to measure a direct pressure difference between the at least one cavity and a pressure in between the two balanced and matched orifices of the reference branch. The input ports of the pressure gauge may be connected to the cavity and a point in between the two balanced and matched orifices.

In some embodiments, a cross section of the opening may enclose the projected optical beam. Phrased differently, it is envisaged that e.g. the same opening through which the optical beam is projected is also used to output a gas flow used for the focusing of the optical beam on the photo-sensitive resist. As also described earlier herein, it is envisaged that the cross section of the opening may encompass the entire area of scanning of the optical beam as well as the physical requirement of free area to allow for free pass for the numerical aperture of the projection optics.

In some embodiments, the pressure sensor may include at least one of a capacitive pressure sensor and a microelectromechanical system (MEMS), such that a miniaturized sensor is readily accommodated inside or in direct connection with the second pneumatic pressure.

In some embodiments, the gas used in the method or the device described herein may be air or nitrogen. It is also envisaged that any other suitable gas may be used, e.g. a gas which is compatible with the photo-sensitive resist and which does not inflict chemical damage to the latter.

According to a fourth aspect of the present disclosure, a pattern generating system is included. The pattern generating system may include a device as described herein, e.g. with respect to the second and third aspects. The pattern generating system may for example operate by performing a method as described herein, e.g. with respect to the first aspect.

The present disclosure relates to all possible combinations of features recited in the claims. Further, any embodiment described with reference to a method according to the first aspect of the present disclosure may be combinable with any one of the embodiments described with reference to any one of the devices according to the second and third aspect of the present disclosure, or with the pattern generating system described with reference to the fourth aspect, or vice versa.

Further objects and advantages of the various embodiments of the present disclosure will be described below by means of exemplifying embodiments.

Brief description of the drawings

Exemplifying embodiments will be described below with reference to the accompanying drawings, in which:

Figure 1 illustrates schematically a cross-section of an embodiment of a device for projection of an optical beam onto a photo-sensitive resist according to the present disclosure;
Figure 2 illustrates schematically the flow of air or gas in embodiments of a method or device for projection of an optical beam onto a photo-sensitive resist according to the present disclosure;
Figure 3 illustrates schematically the flow of air or gas in embodiments of a method or device for projection of an optical beam onto a photo-sensitive resist according to the present disclosure, and
Figures 4a to 4c illustrate the pressure in a cavity, a corresponding pressure sensitivity, and a corresponding flow rate, respectively, in embodiments of a device for projection of an optical beam onto a photo-sensitive resist according to the present disclosure.

In the drawings, like reference numerals will be used for like elements unless stated otherwise. Unless explicitly stated to the contrary, the drawings show only such elements that are necessary to illustrate the example embodiments, while other elements, in the interest of clarity, may be omitted or merely suggested. As illustrated in the figures, the sizes of elements and regions may be exaggerated for illustrative purposes and, thus, are provided to illustrate the general structures of the embodiments.

Detailed description

Exemplifying embodiments will now be described more fully hereinafter with reference to the accompanying drawings. The drawings show currently preferred embodiments, but the invention may be embodied in many different forms and should not be construed as limited to the embodiments set forth herein; rather, these embodiments are provided for thoroughness and completeness.

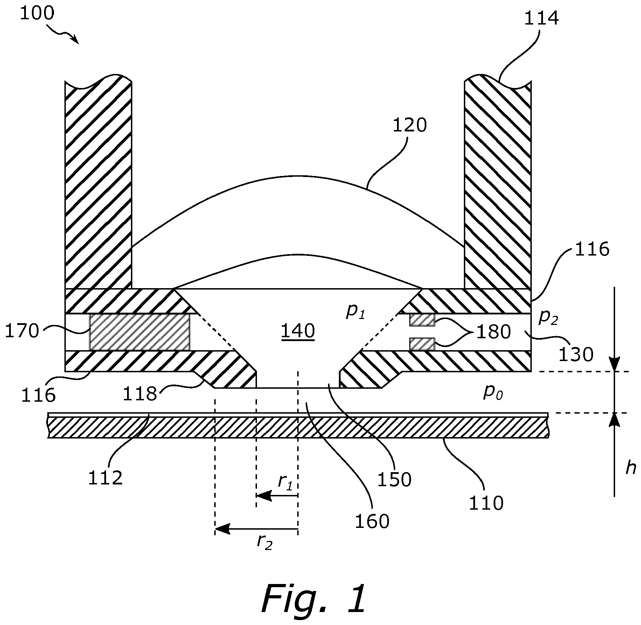

With reference to Figure 1, an embodiment of a device for projection of an optical beam onto a photo-sensitive resist will now be described in more detail.

Figure 1 illustrates a cross-section of a device 100. The device 100 includes a substrate holder (not shown) on which a substrate 110 may be positioned. The substrate 110 is provided, on its upper surface, with a layer of photo-sensitive resist 112 which is to be exposed using the device 100. The device 100 includes projection optics 120, here illustrated in the form of a projection lens 120. It is envisaged of course that the projection optics 120 may include additional components (not shown) needed to project the optical beam onto the photo-sensitive resist. When describing embodiments of a device according to the present disclosure, the terms projection optics and projection lens will be used interchangeably. In the embodiment of the device 100 shown in Figure 1, the projection lens 120 is mounted in a mechanically stable housing 114 and on a sole 116. The sole 116 defines a conical cavity 140. It is envisaged also that other methods and/or features may be used in order to secure the projection lens 120 and/or to define the cavity 140.

Likewise, it is envisaged that the cavity 140 may have other shapes than conical.

The cavity 140 is wide enough to accommodate an angle occupied by an aperture of the projection lens 120. The device 100 further includes a control system (not shown) which allows relative movement between the projection lens (including the housing 114 and the sole 116) and the surface of the photo-sensitive resist 112. Phrased differently, the control system allows for the distance h to be changed in a controlled way.

The sole 116 forms part of a proximity sensor and includes a pneumatic (e.g. air pressure) inlet 130 which may be connected to an external pressurized reservoir of air (not shown). As described earlier herein, the "proximity sensor" may be a theoretical construct only, and the various parts said to form the proximity sensor may also be considered as parts of the device itself. In the illustrated embodiment of the device 100, the inlet 130 also includes a constriction 180 to obtain a controlled and restricted flow of air into the conical cavity 140.

The proximity sensor (formed at least partly by the sole 116) also includes an opening 150. Air may thus flow from the inlet and through the constriction 180 into the cavity 140, through the cavity 140, out from the cavity 140 through the opening 150, into a space (160) formed between the opening 150 and the surface of the photo-sensitive resist 112, and finally into the free space surrounding e.g. the housing 114 of the projection lens 120. The opening 150 is arranged at a first distance to the projection optics (e.g. to the projection lens 120).

As the relative distance h is changed, the effective area of the opening 150 changes and the opening 150 in combination with the possibility to change the distance h thereby enables to vary the space 160. Phrased differently, the pressure-drop from the inlet 130 (or from the constriction 180) to the cavity 140 may be varied. In the embodiment of the device 100 illustrated in Figure 1, the sole 116 includes a slightly lowered surface 118 which has a significantly smaller outer diameter than that of the sole 116, effectively forming the opening 150 as a nozzle for the outflow of air. This may for example provide a well-controlled area of the opening 150 which has a reduced sensitivity to topological deviations of e.g. the substrate 110. In other embodiments, it may be envisaged not to include such a lowered surface. In the embodiment of the device 100 as illustrated in Figure 1, the opening 150 forms part of the outlet from the cavity 140 (and the proximity sensor). Herein, the distance h may be the second distance described earlier herein, i.e. the distance between the opening 150 and the surface of the photo-sensitive resist.

The inner radius of the opening is denoted $r_1$ while the outer radius of the opening is denoted $r_2$.

To measure the pneumatic pressure inside the cavity 140 (denoted pi), the proximity sensor includes a pneumatic pressure sensor 170. The pressure sensor 170 may for example continuously feed a signal indicative of the measured pressure to the control system, using for example a cable and/or wireless alternatives. By controlling for example the distance $h$, and/or the first distance between the opening 150 and the projection optics (lens) 120, based on the pressure measured by the pressure sensor 170, the control system may focus the projection optics with respect to the photo-sensitive resist. As described earlier herein, this may for example be achieved by the control keeping the pressure within the cavity 140 at a nominal level. As the pressure inside the cavity 140 depends on the distance $h$, the control system may thereby provide a focusing of an optical beam which travels through the projection lens 120 down on the surface of the photo-sensitive resist 112. Such a focusing of the optical beam and the optical pattern which is to be exposed may thus be both real-time and automatic, and enable improved lithographic performance. Other methods of focusing, i.e. by adjusting the relative distance between the projection optics and the photo-sensitive resist are also envisaged. For example, the control system may adjust only, or in addition, the first distance (between the opening 150 and the projection optics) as a function of the pressure measured by the sensor 170.

The pressure $p_1$ inside the cavity 140 may be gauged against other pressures, such as e.g. the pressure of the external reservoir (denoted $p_2$), the ambient pressure (denoted $p_0$), or against another pressure supplied in for example a parallel branch as will be described later herein. It is envisaged that additional pressure sensors may be suitably included to measure these other pressures.

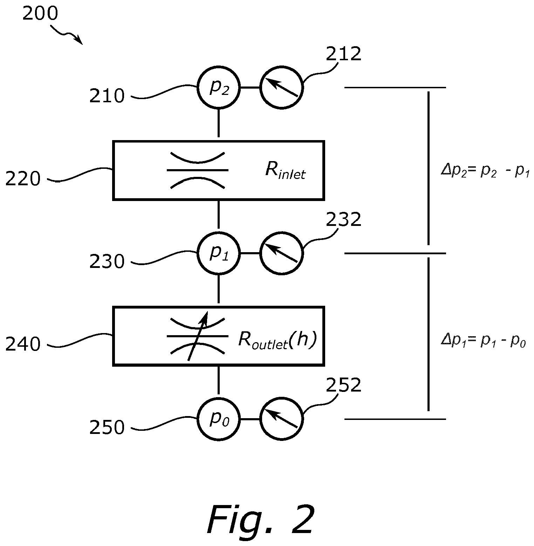

With reference to Figure 2, a flow of air in an embodiment of a device or method according to the present disclosure will now be described in more detail.

Figure 2 illustrates a block-diagram 200 describing a flow of air through a device or method according to embodiments of the present disclosure. The air flows from a pressurized reservoir (e.g. a first domain) 210 held at a pressure $p_2$. If required, the pressure $p_2$ may be gauged using a pressure sensor 212. The air enters through an inlet 220 (including the constriction), facing a pneumatic resistance $R_{inlet)}$ into a cavity (e.g. a second domain) 230 wherein the pressure is $p_1$. With a non-zero air flow, this will cause a pressure-drop $\Delta p_2 = p_2 - p_1$ between the first domain 210 and the second domain 230. The second domain (e.g. the cavity) 230 forms part of a proximity sensor as described earlier herein. The pressure $p_1$ is gauged by a pressure sensor 232. The air continues from the cavity 230 through an outlet (including the opening) from the cavity and through a variable space 240, formed between the opening, e.g. a nozzle, and a surface of the photo-sensitive resist on which the pattern is to be exposed, and faces a pneumatic resistance $R_{outlet}(h)$ which varies with the distance $h$. The air then flows to a third, ambient domain 250 with a pressure $p_0$. A second pressure drop $\Delta p_1 = p_1 - p_0$ develops over the ambient pressure $p_0$. The pressure $p_0$ may be gauged, if needed, by a pressure sensor 252.

As illustrated in Figure 2, the two-step reduction of pressure $p_2 \rightarrow p_1 \rightarrow po$, over the inlet and the variable space formed between the opening and the surface of the photo-sensitive resist may, in analogy to electronics, be seen as a voltage divider where the input voltage (pneumatic pressure) is divided by a fixed resistor (fixed pneumatic resistance, $R_{inlet}$) and a variable resistor (variable pneumatic resistance, $R_{outlet}(h)$), the latter connected to ground (ambient pressure), with the output voltage (pressure inside the cavity) measured over the variable resistor. In this analogy, the variable resistor is varied from its lowest possible value, corresponding to free flow of gas from the opening whenever placed far away from the photo-sensitive resist, to infinity, corresponding to the case when the opening makes perfect contact with the surface of the photo-sensitive resist. Of course, the opening should in reality never touch the resist, implying that the infinite value of gas flow resistance in practice never will appear and that one instead will have some maximum gas flow resistance corresponding to the minimum allowed geometrical distance between the opening and the photo-sensitive resist.

In the electrical analogy of a voltage divider, the pressure $p_2$ acts as the input voltage, the pressure $p_1$ as the output voltage, and the pressure p0 as ground, with the inlet 220 as a fixed resistor and the outlet 240 as a variable resistor, the latter assuming possible values between a fixed minimum value (corresponding to free flow with the opening far away from the photo-sensitive resist) and infinity (corresponding to mechanical contact between the opening and the photo-sensitive resist).

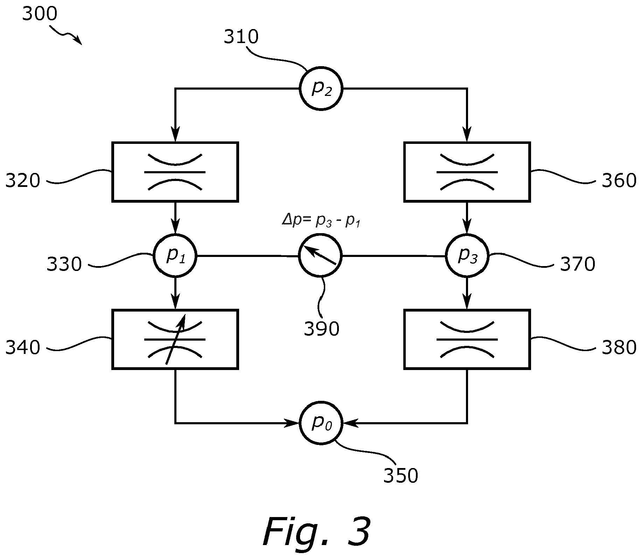

With reference to Figure 3, a flow of air in another embodiment of a device (or method) according to the present disclosure will now be described in more detail.

Figure 3 illustrates a block-diagram 300 describing a flow of air through a device or method according to embodiments of the present disclosure, in which the pressure inside the cavity of the proximity sensor (left path in Figure 3) is measured relative a reference branch (right path in Figure 3).

The left part of the figure shows the path taken by the gas (e.g. air) flowing through the focus system, just as in Fig. 2, from a pressurized reservoir 310, held at pressure $p_2$, via an inlet 320 (including the constriction) of the proximity sensor, which with a non-zero air flow will cause a pressure-drop over to the cavity 330 in the proximity sensor, at pressure $p_1$. As the air flows from the cavity inside the pressure sensor out to the ambient pressure 350, via the variable space 340 formed between the outlet (including the opening, e.g. a nozzle, of the proximity sensor and the surface of the photo-sensitive resist, a second pressure drop occurs over to the ambient 350 pressure $p_0$. In the reference pneumatic branch, gas from the external pressurized reservoir 310 is passed via a constriction or orifice 360, matched in its pneumatic resistance against the inlet 320 of the measurement branch, into a reference cavity 370 of pneumatic pressure $p_3$. From the reference cavity 370, the gas is further passed via a pneumatic reference orifice or constriction 380, matched in its pneumatic resistance against the pneumatic resistance of the pneumatic variable resistance of the outlet in the measurement branch at its nominal distance of separation between the opening and the photo-sensitive resist. The gas is then passed from the reference orifice or constriction 380 over to the same ambient pressure ($p_0$) 350 as the measurement branch. In the setup employing a reference branch for the gauging of pressure, the reference and measurement branches are matched against each other, to have the (second) pressure $p_2$ inside the cavity 330 of the proximity sensor and the reference pressure $p_3$ at the intermediate position of the reference branch equal whenever the separation distance between the opening and the photo-sensitive resist is at its nominal value, implying that the gauging of the (second) pressure $p_1$ against the reference pressure $p_3$ is done around a working point of zero pneumatic pressure difference. The pressures $p_1$ and $p_3$ (and the difference there between) may be gauged by using a pressure gauge 390 connected between the second domain inside the cavity (330) and the reference cavity 370.

Generally, in micro-lithography, the projection of a pattern to a photo-sensitive resist essentially involves four subsystems: (i) a light source, potentially including also a spatial or temporal modulator, (ii) projection optics for imaging to the photo-sensitive resist, (iii) the photo-resist on a solid and essentially planar substrate, and, finally, (iv) an active focusing system to ensure that any deviations in the topography of the photo-sensitive resist is followed by corrective actions and adjustment of the placement of the projection optics assembly, ensuring that an optimal focus is maintained during the exposure of the pattern.

When using the measured pressure inside the cavity as a feedback signal to the control system managing the focusing of the optical beam, as described earlier herein, the nominal level of pressure at which the cavity should be kept is determined by two parameters which may be balanced against each other: i) the pneumatic resistance of an inlet to the cavity, and ii) the variable pneumatic resistance of an outlet from the cavity. The former may essentially be determined by the constriction, together with e.g. any connecting tubes leading to the inlet, while the latter may be determined by the limits set by the free flow of gas, with the lower limit (lowest pneumatic resistance) determined by the case with the opening far from the surface of the photo-sensitive resist, and the upper limit (highest pneumatic resistance) determined by a minimum allowed safe distance between the opening and the photo-sensitive resist.

In steady-state operation, and as function of the varying distance h between the (here assumed essentially planar) surface of the photo-resist and the opening, the mass flow rate $w = w(h)$ of gas through the constriction, from pneumatic pressure $p_2$ of the external pressurized reservoir to pressure $p_1(h)$ internal of cavity, is equal to a mass flow of gas through the (variable) space formed between the opening and the surface of the photo-sensitive resist, from $p_1(h)$ to ambient pressure $p_0$. In terms of pneumatic resistances $R_{inlet}$ and $R_{outlet}(h)$ for the inlet and outlet, respectively, this requirement is in a linear regime where the pneumatic resistances are independent on the flow rate expressed as the condition

$$w(h) = \left(p_2 - p_1(h)\right)/R_{inlet} = (p_1(h) - p_0)/R_{outlet}(h),$$

from which the pressure $p_1(h)$ inside the cavity of the device is obtained from the last equality as

$$p_1(h) = \frac{1 + (p_2/p_0)R_{outlet}(h)/R_{inlet}}{1 + R_{outlet}(h)/R_{inlet}} p_0.$$

Measured relative the pressure at a predesignated nominal distance $h_0$ between the opening and surface of the photo-sensitive resist, at which the nominal pneumatic resistance is $R_{outlet}(h_0)$, the relative deviation $s(h)$ of the pressure inside the cavity can be expressed as the normalized signal

$$s(h) \equiv \frac{p_1(h) - p_1(h_0)}{p_1(h_0)} = \frac{(\xi - 1)\eta(R_{outlet}(h)/R_{outlet}(h_0) - 1)}{(1 + \xi\eta)(1 + \eta R_{outlet}(h)/R_{outlet}(h_0))}.$$

where, for the sake of simplicity in notation it is introduced the short-hand notations $\eta = R_{outlet}(h_0)/R_{inlet}$ for the balance between the pneumatic resistances of the outlet and inlet at nominal distance $h_0$, and $\xi = p_2/p_0$ for the quota between the pressure of the reservoir and the external pressure (i.e. the pressure in the third domain). From the normalized signal $s(h)$, the pressure within the cavity is obtained as $p_1(h) = p_1(h_0)(1 + s(h))$. In terms of the inlet pneumatic resistance $R_{inlet}$ and the nominal pneumatic resistance $R_{outlet}(h_0)$ at nominal separation $h_0$, and given a model of how the outlet pneumatic resistance $R_{outlet}(h)$ varies with the distance $h$, this model describes the variation of the pressure inside the cavity as the separation h between the opening of the device and the photo-sensitive resist is varied from its nominal value.

A question regarding the applicability of measurement of pressure for proximity detection is what the maximum possible deviation of the pressure $p_1(h)$ per deviation of the separation distance $h$ may be. In other words, what the theoretical maximum possible sensitivity may be. As an example, it may be supposed that a given maximum allowed pressure difference $p_2/p_0$ is given, due to a requirement in the limitation of gas flow over the photo-sensitive resist. In order to find a suitable choice of design for the inlet and outlet pneumatic resistances, considering the nominal design separation $h_0$, it is suggested that the derivative of the pressure difference with respect to the separation $h$ may be optimized at the particular design choice of $h = h_0$. This, however, in addition may require a model for the outlet pneumatic resistance $R_{outlet}(h)$, stating the dependence of the separation $h$.

For a (variable) space formed, with the opening at a height h above the surface of the photo-sensitive resist, as a planar annulus (see Figure 1) of inner radius $r_1$ and outer radius $r_2$, considering a gas of dynamic viscosity $\mu$ (typically in units of Pa·s) and density $\rho$ (typically in units of $kg/m^3$), an expression for the pneumatic resistance $R_{outlet}(h)$ (typically in units of Pa·s/kg, expressing the mass flow) may be obtained analytically from the Navier-Stokes equation in a creeping flow approximation, to yield

$$R_{outlet}(h) = \frac{6\mu ln(r_2/r_1)}{\pi h^3 \rho},$$

from which it may be obtained that the pneumatic resistance of the outlet relates to its nominal value at a point of operation $h_0$ as $R_{outlet}(h)/R_{outlet}(h_0) = (h_0/h)^3$. Such a model for the pneumatic resistance of the outlet, with an inverse dependence of the separation to the power of three, may provide an explicit expression for the pressure inside the cavity as

$$p_1(h) = \frac{1 + \xi\eta(h_0/h)^3}{1 + \eta(h_0/h)^3} p_0.$$

The sensitivity of the pressure to changes in the separation distance $h$ from the nominal value $h_0$ may be determined by the magnitude of the derivative $dp_1(h)/dh$, evaluated at the nominal distance $h_0$ of separation and con-

sidered as an expression of the normalized parameters $\eta$ and $\xi$, as

$$\frac{dp_1(h)}{dh} = -\frac{3h_0^3(\xi - 1)\eta}{h^4[1 + \eta(h_0/h)^3]^2} p_0.$$

In order for the maximum sensitivity to occur at the desired working point $h = h_0$, a requirement that the second-derivative of $p_1(h)$ with respect to h vanishes, i.e.

$$\frac{d^2 p_1(h)}{dh^2}\bigg|_{h=h_0} = \frac{6(\xi - 1)(2 - \eta)\eta}{h_0^2(1 + \eta)^3} p_0 = 0,$$

may be obtained and which, for a non-zero quota $\xi$ between the pressures $p_2$ and $p_0$, requires that the quota between the nominal outlet resistance and the inlet resistance is

$$\eta_{opt} = R_{outlet}(h_0)/R_{inlet} = 2.$$

Thus, given that the pneumatic inlet and outlet are matched against each other following the above optimization principle with $\eta = 2$, the maximum sensitivity of the device at the nominal separation $h = h_0$ may be evaluated as

$$\frac{dp_1(h)}{dh}\bigg|_{h=h_0,\eta=2} = -\frac{3(\xi - 1)2}{h_0(1 + 2)^2} p_0.$$

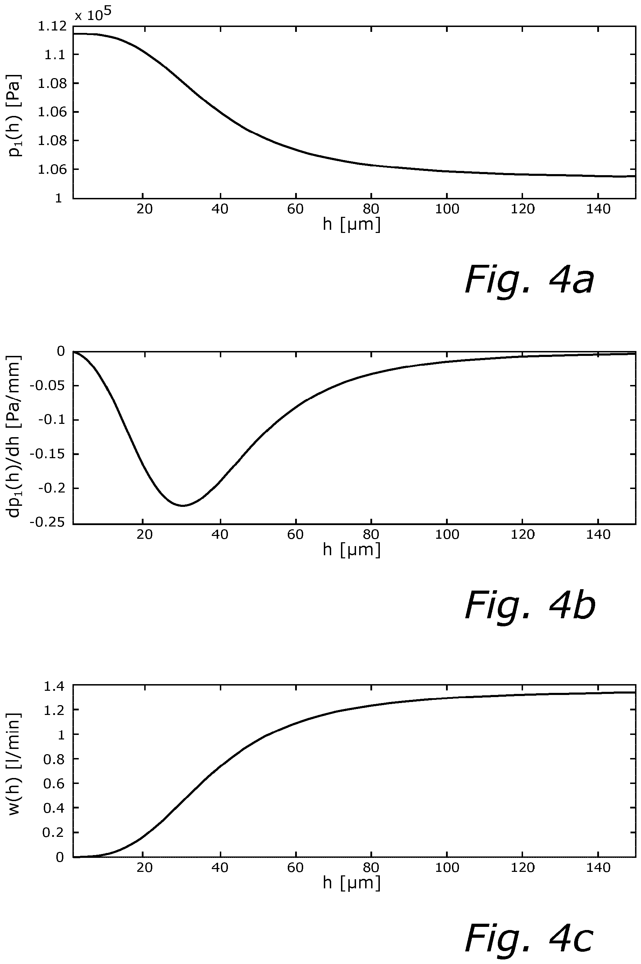

With respect to Figures 4a to 4c, the principal behavior of the above derived expressions is described further using graphs for example parameters $\eta = 2$ and $\xi = 1.1$, corresponding to a setup with nominal height $h_0 = 30\ \mu m$, inner radius of opening $r_1 = 1$ mm, outer radius of opening $r_2 = 2$ mm, and at an ambient pressure of 101.325 kPa (1013.25 mbar). Figure 4a illustrates the pressure $p_1(h)$ within the cavity as a function of the separation distance $h$. Figure 4b illustrates the corresponding pressure sensitivity $dp_1(h)/dh$ as a function of the separation distance $h$. Figure 4c illustrates the corresponding flow rate $w(h)$ as a function of the separation distance $h$. As may be extracted from Figure 4b, the maximum magnitude of the pressure sensitivity (evaluated at distance $h = h_0$) is max($|dp_1(h)/dh|$) = 0.225 Pa/nm, which for focusing applications may constitute a pressure change readily detectable with modern miniaturized sensor technology.

The person skilled in the art realizes that the present disclosure is by no means limited to the embodiments described above. On the contrary, many modifications and variations are possible within the scope of the appended claims. In particular, wherever air is used as an example throughout the application, it is envisaged that other suitable gases may be used, for example nitrogen or any other gas compatible with the chemistry of the photo-sensitive resist.

Although features and elements are described above in particular combinations, each feature or element may be used alone without the other features and elements or in various combinations with or without other features and elements.

Additionally, variations to the disclosed embodiments can be understood and effected by the skilled person in practicing the claimed invention, from a study of the drawings, the disclosure, and the appended claims. In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. A method for focusing of an optical beam during projection onto a photo-sensitive resist, the method comprising:

    passing a first stream of gas from a domain of a first pressure through a constriction to a domain of a second pressure lower than the first pressure;
    measuring the second pressure;

passing a second stream of gas from the domain of the second pressure, through an opening connected to the domain of the second pressure and arranged at a first distance to projection optics for the optical beam, through a space formed between a) the opening and b) a surface of the photo-sensitive resist, and into a domain of a third pressure lower than the second pressure,

and

focusing the optical beam with respect to the photo-sensitive resist by adjusting at least one of the first distance and a second distance between the opening and the surface of the photo-sensitive resist based on the measured second pressure.

2. The method of claim 1, wherein said focusing includes adjusting the second distance such that the measured second pressure is maintained at a nominal level.

3. The method of claim 1 or 2, wherein a cross section of the constriction is dimensioned such that a free flow of gas is kept below a maximum predesignated level.

4. The method of any one of claims 1 to 3, wherein the second pressure is measured relative an intermediate pressure in a reference branch including two orifices balanced to match respective resistances of an inlet to, and the opening connected to, the domain of the second pressure.

5. The method of any one of the preceding claims, wherein the opening connected to the domain of the second pressure contains a cross-section of the projected optical beam.

6. A device (100) for projection of an optical beam onto a photo-sensitive resist, said device being configured to receive a substrate on which at least one layer (112) of a photo-sensitive resist is present, said device comprising:

projection optics (120) configured to project the optical beam onto the photo-sensitive resist when the substrate is received by the device;
a constriction (180);
at least one cavity (140) configured to receive gas from an external pressurized pneumatic reservoir via the constriction;
an opening (150) connected to the at least one cavity and arranged at a first distance from the projection optics, and configured to release the gas from the at least one cavity through a space (160) formable between said opening and a surface of the photo-sensitive resist;
at least one pressure sensor (170) configured to measure a pressure inside the at least one cavity relative an ambient pressure or relative pressure of the pressurized pneumatic reservoir,
and
a control system configured to focus the optical beam with respect to the photo-sensitive resist by adjusting at least one of the first distance and a second distance between the opening and the surface of the photo-sensitive resist based on the measured pressure inside the at least one cavity.

7. A device (100) for projection of an optical beam onto a photo-sensitive resist, said device comprising:

a substrate holder (110) configured to receive a substrate on which at least one layer (112) of the photo-sensitive resist is present;
projection optics (120) configured to project the optical beam towards the substrate holder;
a constriction (180);
at least one cavity (140) configured to receive gas from an external pressurized pneumatic reservoir via the constriction;
an opening (150) connected to the at least one cavity and arranged at a first distance to the projection optics, and configured to release the gas from the at least one cavity therethrough;
at least one pressure sensor (170) configured to measure a pressure inside the at least one cavity relative an ambient pressure or relative pressure of the pressurized pneumatic reservoir,
and
a control system configured to focus the optical beam with respect to the photo-sensitive resist by adjusting at least one of the first distance and a second distance between the opening and the substrate holder based on the measured pressure inside the at least one cavity.

8. The device of claim 6 or 7, wherein the control system is configured to focus the optical beam by adjusting the second distance such that the measured pressure inside the at least one cavity is kept at a nominal level.

9. The device of any one of claims 6 to 8, wherein a cross section of the constriction (180) is designed in such a way that a maximum gas flow is kept below a predefined maximum level.

10. The device of any one of claims 6 to 9, wherein the opening has an area, defined as the product of a circumference of the opening and a gap (h) formable between the opening and the photo-sensitive resist when a substrate is received in the device, large enough to allow for a significant pressure drop from the external pressurized reservoir over to the at least one cavity.

11. The device of any one of claims 6 to 10, further comprising a parallel reference branch including two orifices balanced to match resistances of an inlet to, and the opening connected to, the at least one cavity.

12. The device of claim 11, comprising a pressure gauge configured to measure a direct pressure difference between the at least one cavity and a pressure in between the two balanced and matched orifices of the reference branch.

13. The device of any one of claims 6 to 12, wherein a cross section of the opening encloses the projected optical beam.

14. The device of any one of claims 6 to 13, wherein the pressure sensor comprises at least one of a capacitive pressure sensor and a microelectromechanical system (MEMS).

15. A pattern generating system including the device of any one of claims 6 to 14.

*Fig. 1*

Fig. 2

Fig. 3

*Fig. 4a*

*Fig. 4b*

*Fig. 4c*

Europäisches
Patentamt

European
Patent Office

Office européen
des brevets

## EUROPEAN SEARCH REPORT

Application Number

EP 18 21 5347

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 087 927 A (THOMAS TIM [US] ET AL) 11 February 1992 (1992-02-11) | 1-3, 5-10, 13-15 | INV. G03F9/00 |
| Y | * column 2, line 42 - line 46; claims 6,18; figures 4-6,8,9 * <br> * column 5, line 24 - line 32 * <br> * column 4, line 22 - line 24 * <br> ----- | 4,11,12 | |
| Y | WO 2017/080818 A1 (ASML NETHERLANDS BV [NL]) 18 May 2017 (2017-05-18) * figure 2 * <br> ----- | 4,11,12 | |

TECHNICAL FIELDS
SEARCHED        (IPC)

G03F

The present search report has been drawn up for all claims

| Place of search | Date of completion of the search | Examiner |
|---|---|---|
| Munich | 18 June 2019 | Angioni, Catherine |

EPO FORM 1503 03.82 (P04C01)

## ANNEX TO THE EUROPEAN SEARCH REPORT
## ON EUROPEAN PATENT APPLICATION NO.

EP 18 21 5347

This annex lists the patent family members relating to the patent documents cited in the above-mentioned European search report.
The members are as contained in the European Patent Office EDP file on
The European Patent Office is in no way liable for these particulars which are merely given for the purpose of information.

18-06-2019

| Patent document cited in search report | | Publication date | Patent family member(s) | | Publication date |
|---|---|---|---|---|---|
| US 5087927 | A | 11-02-1992 | DE | 4102746 A1 | 01-08-1991 |
| | | | JP | 3218398 B2 | 15-10-2001 |
| | | | JP | H04348213 A | 03-12-1992 |
| | | | US | 5087927 A | 11-02-1992 |
| WO 2017080818 | A1 | 18-05-2017 | JP | 2018536187 A | 06-12-2018 |
| | | | NL | 2017595 A | 26-05-2017 |
| | | | US | 2019086202 A1 | 21-03-2019 |
| | | | WO | 2017080818 A1 | 18-05-2017 |

EPO FORM P0459

For more details about this annex : see Official Journal of the European Patent Office, No. 12/82